# EUROPEAN PATENT SPECIFICATION

(11) **EP 0 996 317 B1**
(45) Date of publication and mention of the grant of the patent: **11.12.2002**
(21) Application number: 99308017.5
(22) Date of filing: 12.10.1999
(51) Int. Cl.: H05K 1/11

(54) **Structure and method for mounting an electronic circuit unit to a printed board**
Aufbau und Verfahren zum Montieren einer elektronischen Einheit auf eine gedruckte Schaltungsplatte
Assemblage et méthode pour monter une unité électronique sur une plaquette à circuit imprimé

(30) Priority: 19.10.1998 JP 29697298
(43) Date of publication of application: 26.04.2000
(73) Proprietor: ALPS ELECTRIC CO., LTD., Ota-ku Tokyo 145 (JP)
(72) Inventor: Harada, Hiroshi, Fukushima-ken (JP); Terashima, Kiminori, Fukushima-ken (JP)
(74) Representative: Kensett, John Hinton

(56) References cited:
- US-A- 5 303 122
- US-A- 5 458 907
- US-A- 5 692 669

## Description

The present invention relates to a structure and method for mounting an electronic circuit unit to a printed board suitable for use in portable telephones or the like.

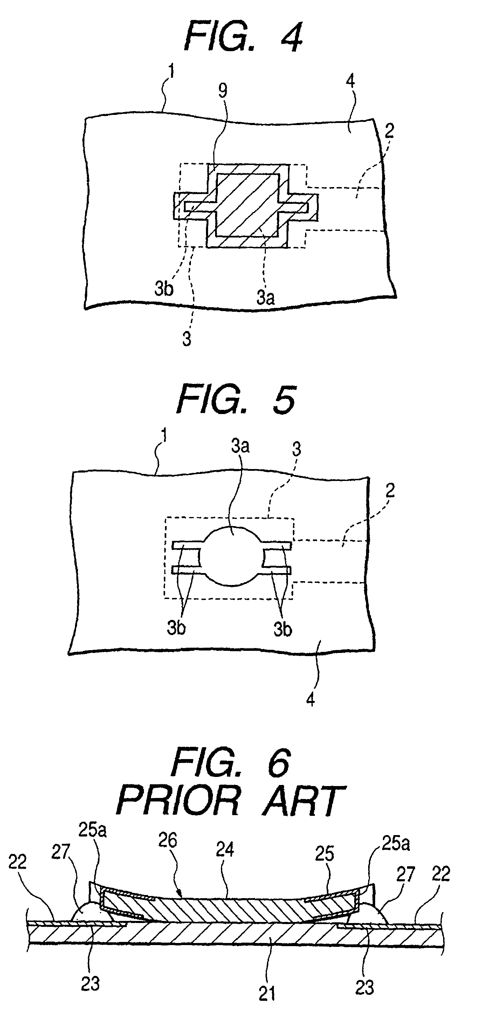

The conventional structure and method for mounting an electronic circuit unit to a printed board will be explained with reference to Fig. 6 through Fig. 8. A printed board 21 serving as a mother board includes conductive patterns 22 formed on the surface thereof and a plurality of lands 23 for soldering, which are formed on the ends of the conductive patterns 22.

And, a circuit board 24 has a plurality of cutout sections 24a formed on the end faces thereof and conductive wiring patterns 25 formed on the upper side thereof, and on the cutout sections 24a are formed end-face electrodes 25a that are connected to the conductive wiring patterns 25.

Further, electronic components (not illustrated) such as resistors, capacitors, and the like are mounted on the circuit board 24 to be connected to the conductive wiring patterns 25, and thus an electronic circuit unit 26 is configured with the one circuit board 24.

And, as shown in Fig. 6, the electronic circuit unit 26 is mounted on the printed board 21 as the mother board of the portable telephone or the like, and the end-face electrodes 25a provided on the circuit board 24 of the electronic circuit unit 26 are bonded onto the lands 23 provided on the printed board 21 through solders 27, whereby the electronic circuit unit 26 is connected to the conductive patterns 22 on the printed board 21, and at the same time it is mounted to the printed board 21.

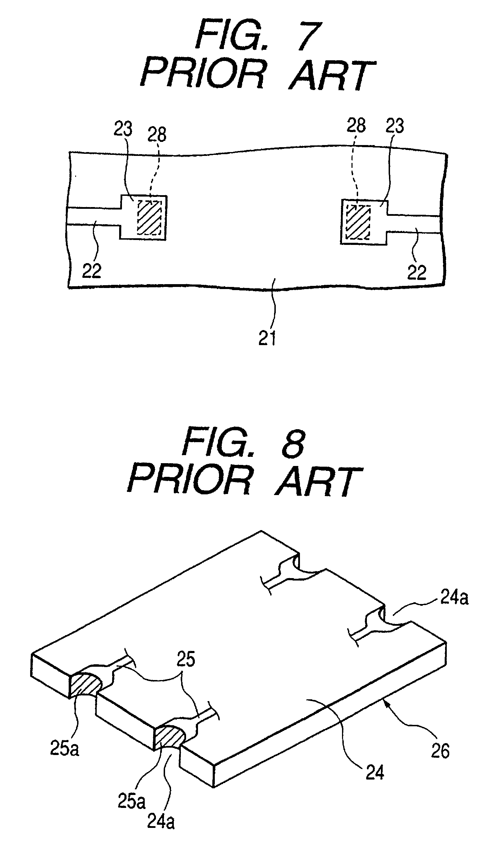

In regard to the method for mounting the electronic circuit unit 26 to the printed board 21, first, cream solders 28 are applied on the lands 23, as shown in Fig. 7.

Next, the electronic circuit unit 26 is mounted on the printed board 21 in a state that the end-face electrodes 25a are located on the cream solders 28, and the printed board 21 having the electronic circuit unit 26 mounted in this state is carried into the heating furnace, whereby the cream solders 28 are melted to solder the end-face electrodes 25a to the lands 23 to form solders 27.

However, in these mounting structure and method, since all of the lands 23 are formed in broad width, and the soldering is made with the cream solders 28 applied on the broad width lands 23, this method is difficult to make a sufficient buildup of the solders 27, and also difficult to secure a good wettability of the solders 27 to the end-face electrodes 25a.

Further, when the circuit board 24 is warped due to a temperature variation, aged deterioration, or the like, the both ends of the circuit board 24 are lifted up as shown in Fig. 6; and especially in such a warped circuit board 24, the cream solders 28 is difficult to wet the end-face electrodes 25a.

Thus, in the conventional structure and method for mounting an electronic circuit unit to a printed board, since all the lands 23 formed on the printed board 21 are configured in broad width, and the soldering is made with the cream solders 28 applied on the broad width lands 23, sufficient buildup of the solders 27 is difficult to make, so that good wettability of the solders 27 to the end-face electrodes 25a cannot be achieved, which is a problem to be solved.

Further, with regard to the circuit board 24 having a warp, the wettability of the cream solders 28 to the end-face electrodes 25a becomes still worse, which is another problem.

According to the present invention, there is provided a structure for mounting an electronic circuit unit to a printed board, comprising a printed board having conductive patterns furnished with lands and an electronic circuit unit having a circuit board furnished with conductive wiring patterns, wherein said printed board is provided with a solder resist on a surface including said lands thereof, said lands are provided with broad width lands exposed from said solder resist and one or more thin width lands tied with said broad width lands, which are exposed from said solder resist, and said broad width lands are soldered to said conductive wiring patterns of said electronic circuit unit.

And, as the second means to solve the problem, the present invention provides a structure such that the broad width lands are formed to be circular.

further, as the third means to solve the problem, the present invention provides a method for mounting an electronic circuit unit to a printed board has a solder resist provided on a surface thereof and has conductive patterns with lands, and the lands are provided with broad width lands exposed from the solder resist and one or more thin width lands tied with the broad width lands, to be exposed from the solder resist. In this configuration, the method comprises the steps of: applying a cream solder on the broad width lands and the solder resist surrounding thereof, and on the thin width lands and the solder resist surrounding thereof, mounting an electronic circuit unit having a circuit board furnished with conductive wiring patterns on the printed board, thereafter, at least heating the cream solder, and soldering the broad width lands to the conductive wiring patterns of the electronic circuit unit.

Further, as the fourth means to solve the problem, the present invention provides a method such that the broad width lands are formed to be circular.

Lands installed on a printed board have broad width lands and thin width lands configured by a resist so that, comparing with the case where the lands installed on the print board have the broad width lands and the thin width lands without using the resist but configured by conductive patterns, the land area becomes large to thereby increase the bonding strength between the lands and the printed board. Further, since the resist is formed in a peripheral edge of the lands, the bonding strength between the lands and the circuit board is increased to thereby improve the bonding strength between the lands and an electronic circuit unit.

Fig. 1 is a sectional view of a major part, which illustrates a preferred embodiment of a structure for mounting an electronic circuit unit to a printed board;

Fig. 2 is an enlarged plan view of a major part of the printed board, of Fig. 1;

Fig. 3 is a perspective view of the electronic circuit unit;

Fig. 4 is an enlarged plan view of a major part of the printed board;

Fig. 5 is an enlarged plan view of a major part of another embodiment of a printed board;

Fig. 6 is a sectional view of a major part of a conventional structure for mounting an electronic circuit unit to a printed board;

Fig. 7 is an enlarged plan view of a major part of the printed board of Fig. 6;

Fig. 8 is a perspective view of the electronic circuit unit of Fig. 6.

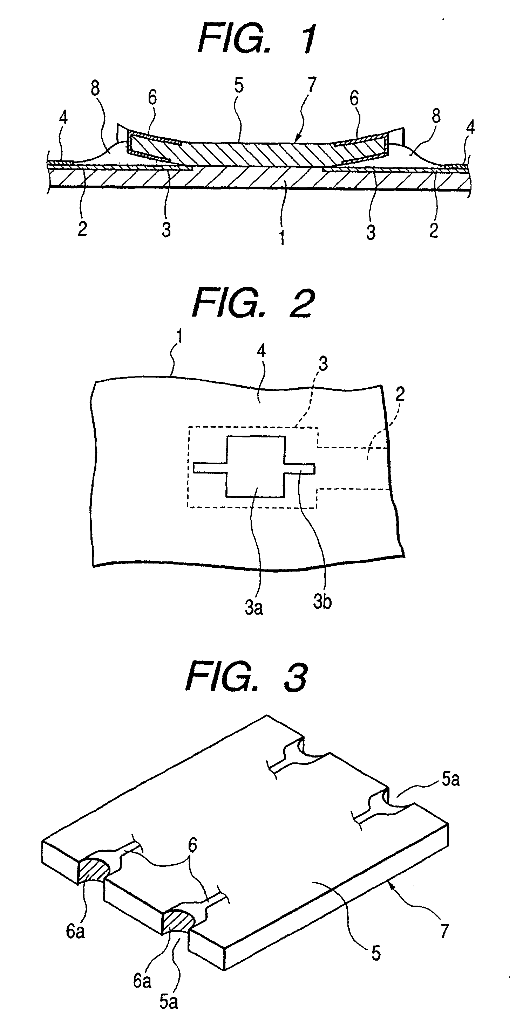

In order to describe a structure for mounting an electronic circuit unit to a printed board and a method for mounting the same of the present invention, the following drawings are provided : Fig. 1 is a sectional view of a major part, which illustrates the structure for mounting an electronic circuit unit to a printed board of the present invention, Fig. 2 is an enlarged plan view of a major part of the printed board, which relates to the structure for mounting the electronic circuit unit to the printed board of the present invention, Fig. 3 is a perspective view of the electronic circuit unit, which relates to the structure for mounting the electronic circuit unit to the printed board of the present invention, and Fig. 4 is an enlarged plan view of a major part of the printed board, which illustrates the method for mounting the electronic circuit unit to the printed board of the present invention.

Next, referring to Fig. 1 through Fig. 4, the structure and the method for mounting the electronic circuit unit to the printed board of the present invention will now be discussed. As shown in Fig. 1, Fig. 2, a printed board 1 serving as the mother board includes conductive patterns 2 formed on the surface thereof and a plurality of lands 3 for soldering, which are formed on the ends of the conductive patterns 2.

A solder resist 4 is formed on the surface of the printed board 1 including the conductive patterns 2 and the lands 3 by means of printing or the like. And, by means of this solder resist 4, a rectangular broad width land 3a and a plurality of thin width lands 3b tied with the broad width land 3a are formed on the surface of each of the lands 3, in a state that both of them are exposed out of the solder resist 4.

Further, the number of the thin width lands 3b may be one for each of the lands 3.

And, as shown in Fig. 1, Fig. 3, a circuit board 5 has a plurality of cutout sections 5a formed on the end faces thereof and conductive wiring patterns 6 formed on the upper side thereof, and on the cutout sections 5a are formed end-face electrodes 6a that are connected to the conductive wiring patterns 6.

Further, electronic components (not illustrated) such as resistors, capacitors, and the like are mounted on the circuit board 5 to be connected to the conductive wiring patterns 6, and thus an electronic circuit unit 7 is configured with one circuit board 5.

And, as shown in Fig. 1, the electronic circuit unit 7 is mounted on the printed board 1 as the mother board of the portable telephone or the like, and the end-face electrodes 6a provided on the circuit board 5 of the electronic circuit unit 7 are bonded onto the broad width lands 3a of the lands 3 provided on the printed board 1 through solders 8, whereby the electronic circuit unit 7 is connected to the conductive patterns 2 on the printed board 1, and also it is mounted to the printed board 1.

And, owing to the effect of providing the thin width lands 3b tied with the broad width land 3a, the solders 8 placed on the thin width lands 3b are drawn near the broad width land 3a. Accordingly, the quantity of the solder 8 on the broad width land 3a increases, and accompanied with the increase, the buildup of the solder 8 on the broad width land 3a can be made still higher, and thereby the soldering with the electronic circuit unit 7 can be made reliable.

And, with regard to the method for mounting the electronic circuit unit 7 to the printed board 1, first, a cream solder 9 is applied on the broad width land 3a and the solder resist 4 surrounding thereof, and on the thin width lands 3b and the solder resist 4 surrounding thereof, as shown in Fig. 4.

Next, the electronic circuit unit 7 is mounted on the printed board 1 such that the end-face electrodes 6a are located on the cream solder 9 on the broad width land 3a, and the printed board 1 with the electronic circuit unit 7 thus mounted is carried into the heating furnace, whereby the cream solder 9 is melted to solder the end-face electrodes 6a of the electronic circuit unit 7 to the broad width land 3a to form solders 8.

In this soldering process, as the cream solder 9 is melted in the heating furnace, the cream solder 9 placed on the solder resist 4 surrounding the thin width lands 3b is drawn toward the thin width lands 3b, and at the same time, the cream solder 9 placed on the thin width lands 3b is drawn toward the broad width land 3a by surface tension, which increases the quantity of the solder 8 on the broad width land 3a, and serves to swell the buildup of the solder 8.

Further, the cream solder 9 placed on the solder resist 4 surrounding the broad width land 3a is drawn toward the broad width land 3a, which increases the quantity of the solder 8 on the broad width land 3a as well as the thin width lands 3b, and serves to swell the buildup of the solder 8.

As the buildup of the solders 8 grow higher in this manner, the soldering of the electronic circuit unit 7 becomes reliable, and the wettability of the solders 8 to the end face electrodes 6a can be bettered and secured thanks to the solders 8 having the buildup grown higher even though there occur lifts on both the ends of the circuit board 5 resulting from a warp of the circuit board 5 by the influence of a temperature variation, aged deterioration, or the like.

Further, Fig. 5 illustrates another embodiment of the present invention, in which the broad width land 3a provided on the land 3 is formed circular, and two pairs of the thin width lands 3b linked with this circular broad width land 3a are placed to face each other.

This circular broad width land 3a makes the surface tension of the cream solder 9 more effective, which forms higher buildup of the solder 8.

The other construction is the same as the foregoing embodiment, and the same symbols are given to the same components to omit the explanations.

In the structure for mounting an electronic circuit unit to a printed board of the present invention, the solder resist 4 formed on the surface of the printed board 1 configures a broad width land 3a and thin width lands 3b linked with this broad width land 3a, whereby the solders 8 placed on the thin width lands 3b are drawn toward the broad width land 3a to thereby increase the quantity of the solder 8 on the broad width land 3a, and accompanied with the increase, higher buildup of the solder 8 can be made on the broad width land 3a. Therefore, the mounting structure of the present invention is able to secure the bonding of the solder 8 with the electronic circuit unit 7.

Further, even if there is a warp on the circuit board 5, higher buildup of the solder 8 will better and secure the wettability to the end face electrodes 6a of the electronic circuit unit 7.

Further, the circular broad width land 3a will enhance the effect of surface tension of the cream solder 9, which makes it possible to form higher buildup of the solder 8 and further secure the bonding of the solder 8 with the electronic circuit unit 7.

In the method for mounting an electronic circuit unit to a printed board of the present invention, a cream solder 9 is applied on the broad width land 3a and the solder resist 4 surrounding thereof, and on the thin width lands 3b and the solder resist 4 surrounding thereof; as the cream solder 9 is melted in the heating furnace, then the cream solder 9 placed on the solder resist 4 surrounding the thin width lands 3b is drawn toward the thin width lands 3b, the cream solder 9 placed on the thin width lands 3b is drawn toward the broad width land 3a by surface tension, and also the cream solder 9 placed on the solder resist 4 surrounding the broad width land 3a is drawn toward the broad width land 3a; and therefore, the quantity of the solder 8 on the broad width land 3a as well as the thin width lands 3b increases, and also the buildup of the solder 8 becomes higher, whereby the bonding of the solder 8 with the electronic circuit unit 7 can be made reliable.

And, even if there is a warp on the circuit board 5, as the buildup of the solder 8 becomes higher, the wettability to the end face electrodes 6a of the electronic circuit unit 7 becomes bettered and secured.

Further, the circular broad width land 3a will enhance the effect of surface tension of the cream solder 9, whereby a higher buildup of the solder 8 can be formed and the bonding of the solder 8 with the electronic circuit unit 7 can be made still more reliable.

## Claims

1. A structure for mounting an electronic circuit unit to a printed board, comprising a printed board having conductive patterns furnished with lands 3 and an electronic circuit unit having a circuit board furnished with conductive wiring patterns, wherein said printed board is provided with a solder resist on a surface including said lands thereof, said lands are provided with broad width lands exposed from said solder resist and one or more thin width lands tied with said broad width lands, which are exposed from said solder resist, and said broad width lands are soldered to said conductive wiring patterns of said electronic circuit unit.

2. The structure for mounting an electronic circuit unit to a printed board, according to Claim 1, wherein said broad width lands are formed to be circular.

3. A method for mounting an electronic circuit unit to a printed board, in which a solder resist is provided on a surface of a said printed board having conductive patterns furnished with lands, and said lands are provided with broad width lands exposed from said solder resist and one or more thin width lands tied with said broad width lands, which are exposed from said solder resist, said method comprising the steps of : applying a cream solder on said broad width lands and said solder resist surrounding thereof, and on said thin width lands and said solder resist surrounding thereof, mounting an electronic circuit unit having a circuit board furnished with conductive wiring patterns on said printed board, thereafter, at least heating said cream solder, and soldering said broad width lands to said conductive wiring patterns of said electronic circuit unit.

4. The method for mounting an electronic circuit unit to a printed board, according to Claim 3, wherein said broad width lands are formed to be circular.

## Patentansprüche

1. Struktur zum Anbringen einer elektronischen Schaltungseinheit an einer gedruckten Platte, die eine gedruckten Platte mit Leitungsmustern, die mit Kontaktflecken (3) ausgestattet sind, und eine elektronische Schaltungseinheit mit einer Schaltungsplatte, die mit Leitungsverdrahtungsmuster ausgestattet ist, umfasst, wobei die gedruckte Platte mit einem Lötresist auf einer Oberfläche, die die Kontaktflecken derselben aufweist, versehen ist, wobei die Kontaktflecken mit von dem Lötresist unbedeckten Kontaktflecken breiter Größe und einen oder mehrere mit den Kontaktflecken breiter Größe verbundene, von dem Lötresist unbedeckte Kontaktflecken schmaler Größe versehen sind, und die Kontaktflecken breiter Größe an den Leitungsmustern der elektronischen Schaltungseinheit gelötet sind.

2. Struktur zum Anbringen einer elektronischen Schaltungseinheit an einer gedruckten Platte gemäß Anspruch 1, bei der die Kontaktflecken breiter Größe kreisförmig ausgebildet sind.

3. Verfahren zum Anbringen einer elektronischen Schaltungseinheit an einer gedruckten Platte, bei dem ein Lötresist auf einer Oberfläche der gedruckten Platte, die mit Kontaktflecken versehene Leitungsmuster aufweist, bereitgestellt wird, und die Kontaktflecken mit von dem Lötresist unbedeckten Kontaktflecken breiter Größe und einen oder mehrere mit den Kontaktflecken breiter Größe verbundene Kontaktflecken schmaler Größe versehen sind, die von dem Lötresist unbedeckt sind, wobei das Verfahren folgende Schritte umfasst: Aufbringen einer Lötpaste auf den Kontaktflecken breiter Größe und das dieselben umgebende Lötresist sowie auf den Kontaktflecken schmaler Größe und das dieselben umgebende Lötresist, Anbringen einer elektronischen Schaltungseinheit, die eine mit Leitungsverdrahtungsmustern ausgestattete Schaltungsplatte aufweist, an der gedruckten Platte, danach mindestens Erwärmen der Lötpaste und Löten der Kontaktflecken breiter Größe an die Leitungsverdrahtungsmuster der elektronischen Schaltungseinheit.

4. Verfahren zum Anbringen einer elektronischen Schaltungseinheit an einer gedruckten Platte gemäß Anspruch 3, bei dem die Kontaktflecken breiter Größe kreisförmig ausgebildet sind.

## Revendications

1. Assemblage pour monter une unité de circuit électronique sur une plaquette de circuit imprimé comprenant une plaquette de circuit imprimé ayant des tracés conducteurs avec des plages et une unité de circuit électronique avec des tracés filaires conducteurs, dans lequel ladite plaquette de circuit imprimé est équipée d'un masque de brasage sur une surface incluant lesdites plages, ces plages présentant des plages de large étendue en épargne du masque de brasage et au moins une plage de faible étendue reliée aux plages de large étendue, qui est en épargne du masque de brasage, lesdites plage de large étendue étant brasées aux tracés conducteurs filaires de l'unité de circuit électronique.

2. Assemblage pour monter une unité de circuit électronique sur une plaquette de circuit imprimé selon la revendication 1, dans lequel lesdites plages de large étendue sont formées pour être circulaires.

3. Procédé pour monter une unité de circuit électronique sur une plaquette de circuit imprimé, dans lequel un masque de brasage est disposé sur une surface de la plaquette de circuit imprimé qui possède un tracé conducteur avec des plages, ces plages présentant des plages de large étendue en épargne du masque de brasage et au moins une plage de faible étendue reliée aux plages de large étendue, qui est en épargne du masque de brasage, le procédé comprenant les étapes de :
- appliquer une pâte à braser sur les plages de grande étendue et sur le masque les entourant et sur les plages de faible étendue et sur le masque les entourant,
- monter sur cette plaquette de circuit imprimé une unité de circuit électronique ayant des tracés filaires conducteurs,
- au moins chauffer la pâte à braser et braser lesdites plages de large étendue avec les tracés filaires conducteurs de l'unité de circuit électronique.

4. Procédé pour monter une unité de circuit électronique sur une plaquette de circuit imprimé selon la revendication 3, dans lequel les plages de larges étendues sont formées pour être circulaires.
